# EUROPEAN PATENT SPECIFICATION

(11) **EP 0 371 663 B1**
(45) Date of publication and mention of the grant of the patent: **15.06.1994**
(21) Application number: 89311910.7
(22) Date of filing: 16.11.1989
(51) Int. Cl.: H01L 27/02

(54) **Integrated circuit output buffer having improved ESD protection**
Ausgangspuffer einer integrierten Schaltung mit einem verbesserten ESD-Schutz
Tampon de sortie de circuit intégré ayant une protection esd modifiée

(30) Priority: 22.11.1988 US 275048; 02.10.1989 US 416099
(43) Date of publication of application: 06.06.1990
(73) Proprietor: AT&T Corp., New York, NY 10013-2412 (US)
(72) Inventor: Smooha Yehuda, Allentown Pennsylvania 18104 (US)
(74) Representative: Buckley, Christopher Simon Thirsk

(56) References cited:
- EP-A- 0 257 774
- PATENT ABSTRACTS OF JAPAN, vol. 6, no. 140 (E-121)[1018], 29th July 1982; & JP-A-57 63 861
- PATENT ABSTRACTS OF JAPAN, vol. 11, no. 286 (E-541)[2733], 16th September 1987; & JP-A-62 84 546
- PATENT ABSTRACTS OF JAPAN, vol. 10, no. 79 (E-391)[2136], 28th March 1986; & JP-A-60 224 259

## Description

This invention relates to integrated circuit output buffers.

The protection of integrated circuits from damage from electrostatic discharge (ESD) events has received considerable attention from integrated circuit (IC) designers. In particular, the input and output buffer stages are susceptible to damage, since they connect directly to the package terminals. That is, an over-voltage condition on the package terminals, as due to an ESD event, can easily damage circuitry that is designed for operation at low voltage, typically 5 volts or less. In the case of MOS input circuitry, ESD typically causes damage to the gate oxides of input buffers, whereas for output circuitry, damage to the drain regions often results. Still other forms of damage are possible. It appears that the output buffers of MOS integrated circuits are more susceptible to damage from ESD events when the output buffers have a metal silicide contact layer on the gate and the source/drain diffused regions; see, for example, "ESD Phenomena and Protection Issues in CMOS Output Buffers" by C. Duvvury et al, IEEE International Reliability Physics Symposium at pages 174-180 (1987).

In order to protect input and output circuitry, over-voltage clamping devices, typically diodes or transistors, may be used. These devices are typically connected between an input/output bondpad and a power supply conductor. In one design, the clamping device is located around the periphery of the bondpad; see U.S. patent 4,806,999 and U.S. patent 4,821,089 co-assigned with the present invention. In order to protect the inputs, various combinations of clamping diodes, transistors, and resistors are used between the input bondpad and the input transistors to limit the voltage that appears at the input gates. Although protective clamping diodes have also been used for the protection of output buffers, these have not provided as high an amount of protection as desired in many cases.

From Patent Abstracts of Japan, Vol. 6, Number 140 (E-121)[1018] and JP-A-5 763 861 it is known to provide protective diodes for an output buffer as well as resistive elements directly in the source and drain regions of the output transistors.

One problem with protecting output buffers is that the value of the resistors traditionally used to protect input circuitry is typically on the order of hundreds or even thousands of ohms. Such a value is much too high for use with output buffers, since the buffer must sometimes drive large capacitive loads (e.g., typically greater than 10 picofarads, and often greater than 100 picofarads). Therefore, an output resistor on the order of several hundred ohms (or more) would reduce the output switching speed of the buffer to an unacceptably slow value. In addition, the sinking and sourcing current capability of the buffers would be degraded with the use of a large value resistor. For these reasons, it has been considered desirable to use as good a conductor as possible between the output buffer and the bondpad, in order to allow the external load to be switched at high speed. This normally means that the metal (e.g., aluminum) layer of the integrated circuit is used to form the conductor between the output buffer and the bondpad. However, in some cases wherein only a single metal level is present on the integrated circuit, layout considerations have caused the underlying polysilicon or metal silicide layer to be used for this purpose. That is, when an aluminum conductor is required to overlie the output buffer, as for a power bus, a silicide layer is used to connect the output buffer to the bondpad. However, unless required for this or other purposes, the use of a polysilicon or silicide link between the output buffer and the bondpad has been avoided in the prior art, to preserve high performance.

According to this invention there is provided an integrated circuit as claimed in claim 1.

As will be appreciated from the following description with reference to the drawings, a resistor is included between the drain of the n-channel transistor in a given buffer and the corresponding bondpad. In a preferred embodiment, multiple n-channel output transistor drain regions are each connected to the bondpad through a separate resistor. The resistors are desirably formed in a deposited layer, typically doped polysilicon or metal silicide, overlying the semiconductor substrate. The bondpad is also connected to over-voltage clamping means, typically one or more diodes or transistors.

The invention will now be described with reference to the accompanying drawings, in which:
Fig. 1 shows schematically an output buffer;
Fig. 2 shows a typical layout of the output buffer of Fig. 1;
Fig. 3 shows an output buffer embodying the invention;
Fig. 4 shows schematically another output buffer embodying the invention; and
Fig. 5 shows a physical layout of the output buffer of Fig. 4.

The present invention relates to an integrated circuit having improved protection against electrostatic discharge (ESD). I have found that the inventive technique affords a significant improvement as measured by the "human body model", discussed below, even for silicided output buffers that are the most susceptible to breakdown. Furthermore, the present technique has a minimal effect on the performance of the protected output buffer, and may be implemented in CMOS technology without additional processing steps.

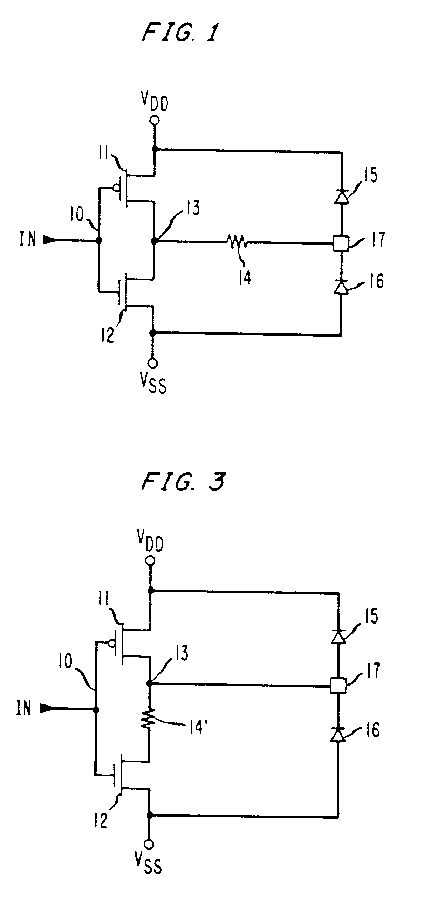

Referring first to Fig. 1, an output buffer in CMOS technology comprises p-channel transistor 11 and n-channel transistor 12 having their drains connected to a common buffer output node 13. A silicide resistor 14 is connected between the node 13 and the output bondpad 17. Furthermore, voltage clamping diodes 15 and 16 are connected to the bondpad and to the power supply conductors V_{DD} and V_{SS} accordingly. As discussed below, the diodes 15 and 16 may be disposed around the periphery of the bondpad to minimize resistance and inductance, thereby ensuring fast clamping action for maximum protection. Surprisingly, I have found that the value of resistor 14 in this arrangement may be very low, allowing good performance, while still achieving a significant improvement in ESD protection on the human body model test, discussed below. In a typical case, the value of this resistor is in the range of 2 to 10 ohms, although a higher value is suitable in the case of a relatively small output buffer driving a small load. I estimate that a value up to about 20 ohms is useful for small output buffers, whereas a value as low as 1 ohm still provides useful protection, while allowing for high performance from a relatively large output buffer.

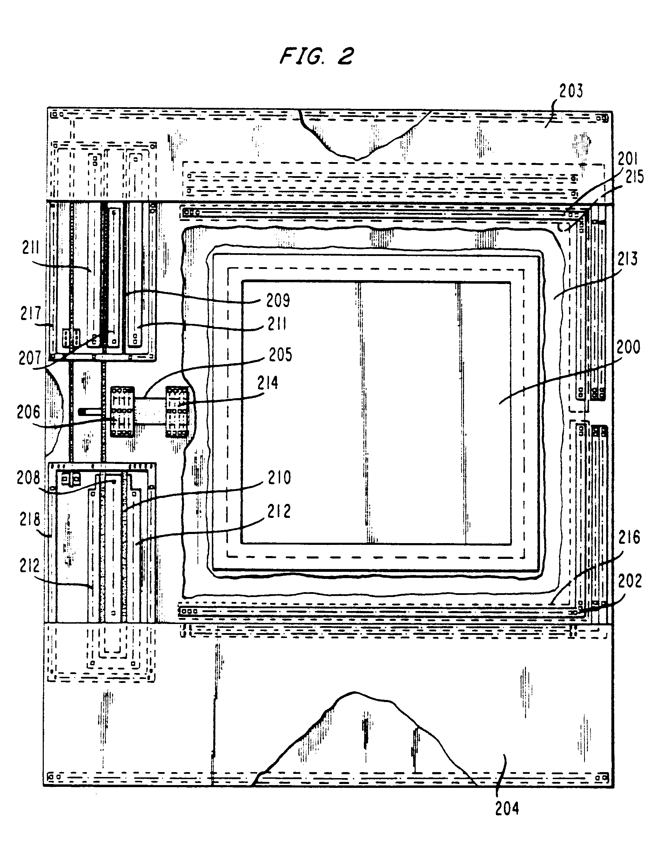

Referring to Fig. 2, a top view of a typical layout of the buffer of Fig. 1 is shown. An output bondpad, typically aluminum, has a central portion 200 that is used for wire bonding to a package terminal. The periphery 213 of the bondpad is covered with an insulator, typically being a portion of a silicon dioxide or silicon nitride "cap" layer. The top half (as viewed) of the periphery of the bondpad extends down through contact windows 201 to a p-type semiconductor region 215, which forms the anode of diode 15. The underlying n-type semiconductor region (typically a n-tub) forms the cathode of diode 15, and is connected through contact windows to the positive power supply voltage (V_{DD}) conductor 203. Similarly, the bottom half of the bondpad is connected through contact windows 202 to the n-type cathode region 216 of diode 16. The underling p-type anode region of diode 16 (typically a p-tub) is connected through contact windows to the negative power supply voltage (V_{SS}) conductor 204. A further explanation of these protective diodes may be found in the above-noted U. S. patent 4,806,999.

The metal silicide link 205 connects the bondpad to the output buffer, and provides the required resistance for proper ESD protection. For example, a link of titanium silicide having a thickness of 100 nanometers (1000 angstroms), a width of 10 micrometers, and a length of 20 micrometers provides a resistance of about 3 ohms. Other geometries may readily be determined that obtain the desired resistance, based upon the resistivity of the silicide employed, which is about 1.5 ohms per square in the case of titanium silicide. The bondpad is connected to one side of the silicide resistor through contact windows 214. The drains of the p and n channel output transistors underlie metal contact regions 207 and 208, respectively, which contact the other side of the resistor through contact windows 206. Regions 209 and 210 are the gate electrodes, and regions 211 and 212 are the metal contacts to the sources of the p and n channel output transistors, respectively. The p-channel transistor is surrounded by an optional guard ring, comprising a metal layer 217 connected to V_{DD}, which contacts a n-type ring located thereunder. Similarly, the n-channel transistor is surrounded by an optional guard ring comprising metal layer 218 connected to V_{SS}, which contacts a p-type ring thereunder.

It is typically desirable to obtain a failure voltage of at least 2000 volts on the human body model test (although a lower amount is suitable for some applications). Test results show that this may be obtained using a resistor of about 8 ohms in the manner described. Still other values may be selected depending on the protection desired and output load.

In order to distinguish the case wherein a metal silicide interconnect has been used in the prior art between the output buffer and the bondpad for layout reasons, the embodiment of FIGS. 1 and 2 is described in terms of integrated circuits having two (or more) metal interconnect levels. For example, in the illustrative embodiment of FIG. 2, the central portion of the metal bondpad 200 includes both the first and second metal layers. Similarly, the V_{DD} and V_{SS} busses 203 and 204 are formed from both the first and the second metal layer, whereas the source/drain contacts 207, 208, 211, 212 are formed from only the first level metal layer. In the case wherein two (or more) metal levels are avallable, layout problems do not require that the silicide layer be used for the bondpad-to-output-buffer interconnect. Hence, it has been avoided in the prior art due to a lack of understanding of its beneficial effect when combined with clamping diodes for ESD protection.

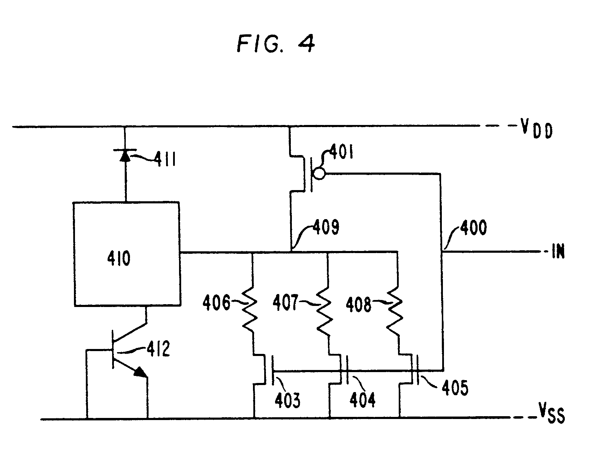

As shown in Figs. 1 and 2, the protective resistor 14 is connected between the output node 13 and the bondpad 17. This provides for a convenient layout for the buffer circuitry. However, it is alternately possible to connect the protective resistor between the drain of the n-channel transistor 12 and the output node 13. This results in the connection of the protective resistor as shown as 14' in the embodiment of the invention shown in Fig. 3. This still results in a substantial improvement in ESD performance, since the n-channel transistor in practice is more susceptible to ESD damage than the p-channel transistor 11. Furthermore, it allows the p-channel device, which typically tends to have a lower performance than the n-channel device, to be connected directly to the bondpad. Note that it does not appear that the connection of Fig. 3 has been required in the prior art for layout purposes with either single level or multi-level interconnect techniques. Note also that in either case, the protective resistor is in the path between the drain of the n-channel transistor 12 and the bondpad 17.

A silicided resistor has been shown in the illustrative embodiment herein, which is compatible with the "salicide" technique for forming silicided source, drain, and gate electrodes. It is of course very advantageous to be able to solve the ESD problem in such structures, which are more susceptible to ESD than other designs. Furthermore, the salicide technique is becoming increasingly common with integrated circuits at the sub-micron level. However, the present invention is not limited to the use of silicided resistors, or with the salicide technique. For example, a doped polysilicon resistor may be used to provide the resistance in the desired range. Furthermore, it is well known to form transistors having silicided gate regions, but which do not include a silicide layer on the source/drain regions. Such transistors also obtain improved ESD protection by the use of the inventive technique.

A presently preferred embodiment of the invention utilizes multiple resistors. This is illustrated in Fig. 4, which shows a CMOS output buffer protected in this manner. This buffer comprises a p-channel pull-up transistor 401 and multiple (e.g., 3) n-channel pull-down transistors 403, 404 and 405. Note that in practice, transistors 403, 404 and 405 typically are constructed using a common gate electrode, and may be considered a single pull-down device having multiple drain (and source) regions. This is often used in prior art designs in order to increase the output drive capability of the buffer. Similarly, although transistor 401 is shown as a single device, it may also comprise multiple source and drain regions for increased drive capability, as in prior art designs. The gates of the transistors are coupled to an input node 400, which receives the buffer input signal.

Included in this embodiment are resistors 406, 407, and 408. These resistors connect the drains of the n-channel pull-down device to the output node 409, which is connected to the bondpad 410. I have found that the use of multiple resistors aids in reducing the likelihood of damage from ESD events, allowing for higher test voltage ratings according to standard ESD testing procedures. The resistors typically each have a value in the range of 1 to 100 ohms, and more typically in the range of 5 to 50 ohms. In the preferred embodiment, the resistors are formed in a conductive layer overlying, and insulated from, the substrate. The resistors may be conveniently implemented using a doped polysilicon or metal silicide conductor layer. They may be formed in the same layer used to form the gate electrodes, if desired.

It is known in the prior art that resistors may also be formed by doped regions in the semiconductor substrate. For example, n+ regions formed in a p-tub could be envisioned as resistors. However, in that case, it is necessary to use a n+ guard ring region located in a n-tub surrounding the resistors, in order to protect against latch-up. The latch-up could otherwise occur due to the injection of minority carriers into the substrate. However, forming the resistors in a deposited conductive layer overlying, and insulated from, the substrate (e.g., a polysilicon or silicide layer) makes the guard ring unnecessary. In still another prior art technique, resistors are formed directly in a tub region, for example a n-tub. However, I have found that the use of resistors formed in a deposited conductor provides for a more compact design. This is due in part to the spacing requirements for preventing "short channel" effects when a n-tub resistor is used. Therefore, the presently preferred embodiment utilizes multiple resistors formed in a deposited conductor layer.

I postulate that the use of the multiple resistors reduces the likelihood that an ESD event will cause a failure due to "hot spots". Such hot spots are due to high currents resulting from an ESD event, and may destroy a drain region of an output transistor. By dividing the current paths to the n-channel devices through the multiple resistors, the likelihood of a hot spot failure in even a single one of the devices is reduced. It is known in the art that the n-channel devices are more prone to failure than p-channel devices. Hence, the illustrative embodiment shows the resistors connected only to the drains of the n-channel devices. This provides adequate protection in many cases, while avoiding a performance penalty with respect to the p-channel device.

The resistors typically have a resistance of at least 1 ohm, in order to obtain enhanced ESD protection.

Also included in the inventive output buffer are one or more over-voltage clamping devices connected to the bondpad. These may be diodes, transistors, or a combination, and serve to limit the voltage swings that are in excess of normal operaring voltages. For example, in Fig. 4 diode 411 provides protection from high positive voltages at the bondpad. Similarly, transistor 412 protects from high negative voltages. Note that these devices conduct to the V_{DD} and V_{SS} power supply voltage conductors, respectively. Even though these conductors are not connected to power supply voltages when the integrated circuit is not connected in a circuit (e.g., as during manufacture or shipping), they provide access to a large substrate capacitance and resistance that helps dissipate the ESD energy.

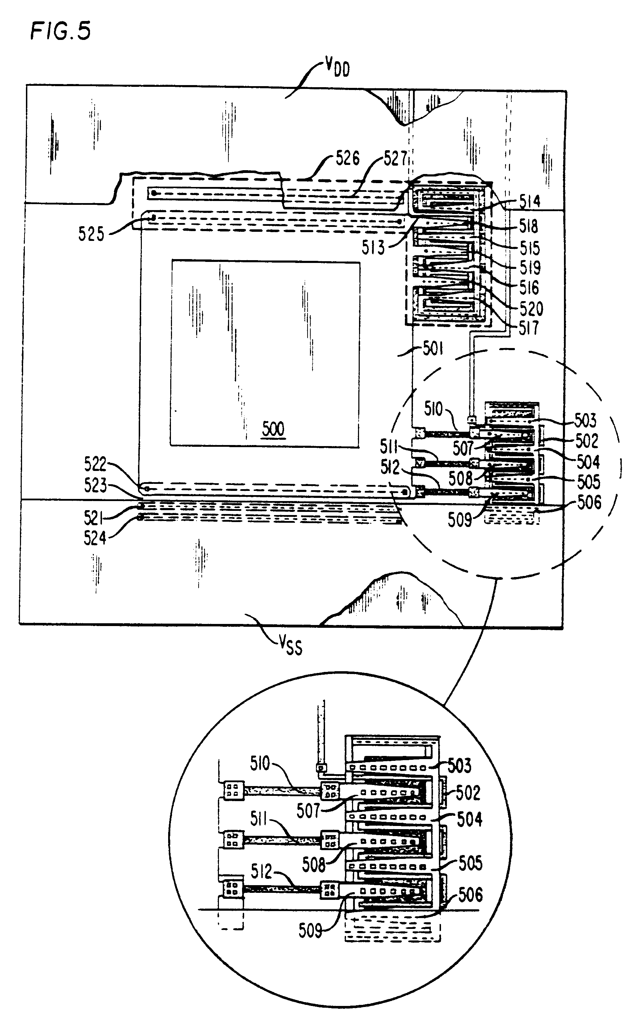

Referring to Fig. 5, a physical layout of an illustrative integrated circuit output buffer and its associated bondpad is shown. The metallic bondpad 500 (typically aluminum) is covered around its edges with a dielectric region 501, typically deposited silicon dioxide or silicon nitride. The central portion of the bondpad is left free of the dielectric, allowing for a wire bond connection to a package terminal. Along the lower periphery of the bondpad (as viewed) is located a negative over-voltage clamping device, implementing bipolar transistor 412 in Fig. 4. This transistor comprises a n+ emitter region 521, a n+ collector region 522, and a p-type base region 523. The base region is a portion of the p-tub in which the transistor is formed, with the p-tub being connected to the V_{SS} power supply conductor by means of p+ tub tie contact region 524. This bipolar device serves to limit negative voltage swings to about 0.5 volts with respect to the V_{SS} conductor. Note that other protective devices (e.g., a diode or metal gate field effect transistor) may alternately be used to limit the negative voltage on the bondpad. Along the upper periphery of the bondpad is located a protective diode, comprising p+ anode region 525, which is formed in a n-tub region 526, which serves as the cathode. The n-tub region 526 is connected to the V_{DD} power supply conductor by means of n+ tub tie contact region 527. This diode serves to limit the positive voltage swings to about 0.5 volts positive with respect to the V_{DD} conductor.

The n-channel output device comprises a serpentine gate electrode 502 which extends between multiple source regions 503 ... 506 and multiple drain regions 507 ... 509. Note that the source and drain regions are overlaid by triangular metal electrodes. Each drain region is connected to the bondpad through a resistor, being regions 510 ... 512. In the illustrative embodiment, the resistors are physically connected directly to the bondpad around its edge. However, they may alternately be connected to a conductor that connects to the bondpad. In the illustrative case, the resistors are tantalum silicide formed on top of doped polycrystalline silicon, and have a sheet resistivity of 2.5 ohms per square. With a width of 3 micrometers, a length of 24 micrometers, and a thickness of about 0.5 micrometers, they provide a resistance of 20 ohms between each drain region and the bondpad. As is apparent, other resistor materials (e.g., doped polysilicon, molybdenum silicide, titanium silicide, cobalt silicide, etc.) will have different resistivities, and the resistor geometry may be chosen as needed to obtain the desired resistance. If desired, silicide resistors may be formed during the "salicide" process that forms the silicide on gate, source, and drain regions. Also shown in Fig. 5 is the p-channel pull-up transistor, comprising serpentine gate electrode 513, multiple source regions 514 ... 517 and multiple drain regions 518 ... 520. As can be seen, the drain regions are connected by means of aluminum conductors directly to the bondpad.

The present technique has been used with output buffers on an IC chip implemented in 1.25 micrometer CMOS technology. The buffers were found to have ESD protection typically in excess of 2500 volts, as measured by the "human body model" test. This is an industry standard test that involves discharging a 100 picofarad capacitor through a 1500 ohm resistor into the output pin connected to the bondpad. In these tests, the V_{SS} or V_{DD} pins were grounded, while the other pins were left floating. In addition to this test, the latch-up resistance of the chip was found to be at a suitably high level.

While three resistors (for each of the three drain regions) have been shown in the illustrative embodiment, any number may be employed, depending on the design of the output buffer. In general, output buffers requiring higher current drive capabilities utilize a greater number of drain regions, and hence a greater number of resistors. For example, in one current design, 17 drain regions are used. While two voltage clamping devices are typically used (one for each polarity), that is not necessary in all cases. For example, if the p-channel device is wide enough, the p+/n-tub diode (regions 525 ... 527) may be omitted, because the junction formed by the p+ drain and n-tub will provide for the positive clamping action. Still other variations will be apparent to a person of skill in the art.

Although the illustrative embodiment has shown the present invention in terms of CMOS technology, it may be used with other types of integrated circuits as well. The inventive technique may be used to protect integrated circuits formed with III-V semiconductor materials as well.

## Claims

1. An integrated circuit comprising an output buffer having a p-channel pull-up transistor (11) and an n-channel pull-down transistor (12) having their drains coupled to a common bondpad (17) which is connected to an external conductor, and voltage clamping means (15,16) connected to said bondpad, CHARACTERIZED BY a resistor (14') having a resistance of greater than 1 ohm and less than 20 ohms connected between the drain of said n-channel transistor and said bondpad, wherein said resistor is a doped polysilicon or silicide resistor, and the drain of said p-channel transistor is directly connected to said bondpad.

2. An integrated circuit as claimed in claim 1 wherein said transistors have silicided gate, source, and drain electrodes, and said resistor is a silicided resistor.

3. An integrated circuit as claimed in claim 1 or 2 wherein said voltage clamping means is a pair of diodes, the first diode of said pair has a p-type anode region connected to said bondpad and an n-type cathode region connected to a positive power supply voltage conductor, and the second diode of said pair has an n-type cathode region connected to said bondpad and a p-type anode region connected to a negative power supply voltage conductor.

4. An integrated circuit as claimed in any preceding claim comprising at least two levels of metal conductors.

## Patentansprüche

1. Integrierte Schaltung umfassend: einen Ausgangspuf£er mit einem p-Kanal-Pull-up-Transistor (11) und einem n-Kanal-Pull-Down-Transistor (17) deren Drainanschlüsse an einem gemeinsamen Kontaktierungsfleck (18) angeschlossen sind, der mit einem externen Leiter verbunden ist, und
eine an den Kontaktierungsfleck angeschlossene Spannungs-Klemmeinrichtung (15, 16),
gekennzeichnet durch
einen zwischen den Drainanschluß des n-Kanal-Transistors und den Kontaktierungsfleck angeschlossenen Widerstand (14') mit einem Widerstandswert, der größer als 1 Ohm und kleiner als 20 Ohm ist, wobei der Widerstand ein dotierter Polysilicium- oder Silicid-Widerstand ist und der Drainanschluß des p-Kanal-Transistors unmittelbar an den Kontaktierungsfleck angeschlossen ist.

2. Integrierte Schaltung nach Anspruch 1, bei der die Transistoren silicierte Gate-, Source- und Drainelektroden besitzen, und der Widerstand ein silicierter Widerstand ist.

3. Integrierte Schaltung nach Anspruch 1 oder 2, bei der die Spannungs-Klemmeinrichtung ein Diodenpaar ist, dessen erste Diode mit einer Anodenzone vom p-Typ an dem Kontaktierungsfleck und mit einer Kathodenzone vom n-Typ an dem positiven Anschluß einer Spannungsversorgung angeschlossen ist, und dessen zweite Diode mit einer Kathodenzone vom n-Typ an dem Kontaktierungsfleck und mit einer Anodenzone vom p-Typ an dem negativen Anschluß einer Spannungsversorgung angeschlossen.

4. Integrierte Schaltung nach einem der Ansprüche 1 bis 3, die mindestens zwei Metalleiterschichten aufweist.

## Revendications

1. Circuit intégré comprenant un tampon de sortie ayant un transistor d'excursion haute à canal p (11) et un transistor d'excursion basse à canal n (12) dont les drains sont couplés à une plage de connexion commune (17) qui est connectée à un conducteur externe, et un moyen de fixation de niveau de tension (15,16) connecté à ladite plage de connexion, CARACTERISE PAR une résistance (14') ayant une résistance supérieure à 1 ohm et inférieure à 20 ohms connectée entre le drain dudit transistor à canal n et ladite plage de connexion, dans lequel ladite résistance est une résistance en polysilicium ou siliciure dopé, et le drain dudit transistor à canal p est connecté directement à ladite plage de connexion.

2. Circuit intégré selon la revendication 1, dans lequel lesdits transistors ont des électrodes de grille, source et drain siliciées, et ladite résistance est une résistance siliciée.

3. Circuit intégré selon la revendication 1 ou 2, dans lequel ledit moyen de fixation de niveau de tension est une paire de diodes, la première diode de ladite paire a une région d'anode de type p connectée à ladite plage de connexion et une région de cathode de type n connectée à un conducteur de tension d'alimentation positif, et la seconde diode de ladite paire a une région de cathode de type n connectée à ladite plage de connexion et une région d'anode de type p connectée à un conducteur de tension d'alimentation négatif.

4. Circuit intégré selon l'une quelconque des revendications précédentes comprenant au moins deux niveaux de conducteurs métalliques.
